# EUROPEAN PATENT SPECIFICATION

(11) **EP 1 678 829 B1**
(45) Date of publication and mention of the grant of the patent: **21.04.2010**
(21) Application number: 04770247.7
(22) Date of filing: 13.10.2004
(51) Int. Cl.: H03K 23/54

(54) **FREQUENCY DIVIDER**
FREQUENZTEILER
DIVISEUR DE FREQUENCES

(30) Priority: 23.10.2003 EP 03103937
(43) Date of publication of application: 12.07.2006
(73) Proprietor: NXP B.V., 5656 AG Eindhoven (NL)
(72) Inventor: STIKVOORT, Eduard, F., NL-5656 AA Eindhoven (NL); SANDULEANU, Mihai, A., T., NL-5656 AA Eindhoven (NL)
(74) Representative: Bird, William Edward
(86) International application number: PCT/IB2004/052080
(87) International publication number: WO 2005/041413

(56) References cited:
- EP-A- 0 270 191
- DE-A- 3 546 132
- PATENT ABSTRACTS OF JAPAN vol. 005, no. 015 (E-043), 29 January 1981 (1981-01-29) & JP 55 145439 A (TOSHIBA CORP), 13 November 1980 (1980-11-13)

## Description

The invention relates to a frequency divider.

Frequency dividers are well-known and widely-used devices in applications as Phase Locked Loops (PLLs), prescalers, digital receivers. Normally a frequency divider requires flip-flops coupled in a convenient manner for obtaining a desired frequency division.

The actual trends in semiconductor technology is shrinking transistors size for improving the speed of the circuits and downsize the supply voltages for the integrated circuits for reducing a dissipation power of the chips.

US-A 6,424,194 describes ultra high-speed circuits using current-controlled CMOS (C3MOS) logic fabricated in conventional CMOS process technology. An entire family of logic elements including inverters/buffers, level shifters, NAND, NOR, XOR gates, latches, flip-flops and the like are implemented using C3MOS techniques. Optimum balance between power consumption and speed for each circuit application is achieved by combining 15 C3MOS logic with low power conventional CMOS logic. The combined C3MOS/CMOS logic allows greater integration of circuits such as high-speed transceivers used in fiber optic communication systems. It is observed that the circuits presented in the above-mentioned patent still use at least two stacked transistors, which make them less suitable for relative low-voltage (1.2, .9 or .7 V) supply applications. By stacking transistors, the threshold 20 voltages of the upper transistors increase due to the back-bias effect. As a consequence, the upper transistors do not have maximum gain and maximum speed of operation.

EP-A-0 270 191 describes a divider circuit comprising a first flip-flop whose output is connected to a D input of a second flip-flop, a negate output of the second flip-flop being connected to a D input of the first flip-flop. A clock input signal is applied to a clock input of the first flip-flop. The clock signal is also applied to a clock input of the second flip-flop via a delay circuit.

It is therefore an object of the invention to provide a frequency divider suitable 25 for low-voltage supply voltages and high speed of operation.

The invention is defined in the independent claim. Dependent claims describe advantageous embodiments.

In accordance with the present invention, the frequency divider comprises a first flip-flop having a first clock input for receiving a clock signal, a first data input and a first output. The divider further comprises a second flip-flop having a second clock input for receiving a second clock signal that is substantially in anti-phase with the clock signal inputted into the first clock input, a second data input coupled to the first output. The second flip-flop further comprises a second output and a third output, the second and third outputs (Q2, Qa2) providing signals that are mutually in anti-phase. The third output is coupled to the first data input. A period of the clock signal is of the same order of magnitude as a delay through an inverted stage of the divider.

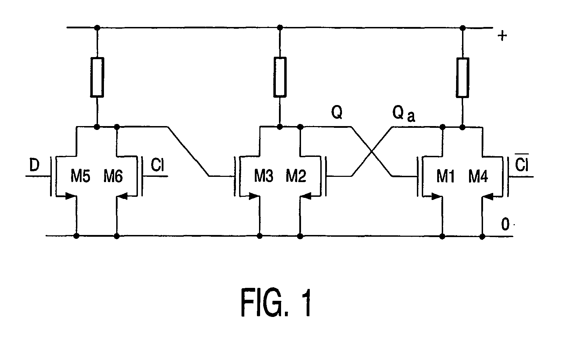

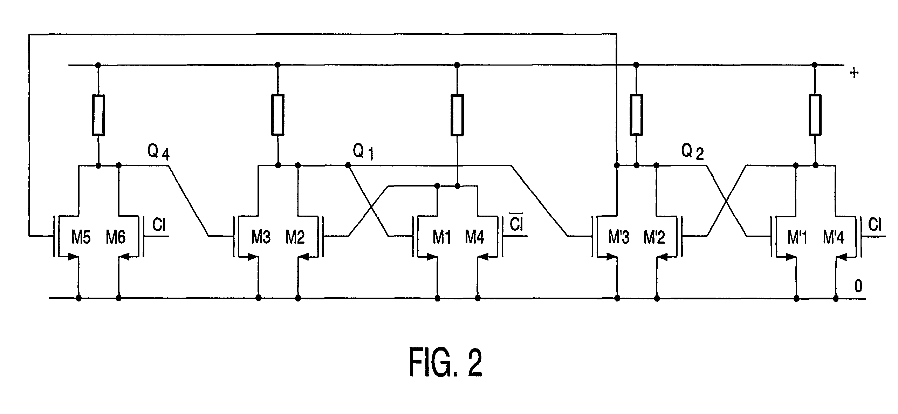

A prior art frequency divider is shown in Fig. 2. It comprises first and second flip-flops, each flip-flop, each of them being implemented as shown in Fig. 1. In Fig. 1, transistors M1 and M2 implement a R-S flip-flop, which is controlled by a clock signal having two components that are mutually in anti-phase C1 and C̅1̅, respectively. An input signal D is inputted via a controlled inverter M5, M6 to an input of the flip-flop. Two flip-flops of this kind are coupled as in Fig. 2 for providing a frequency divider. It is observed that there is a feedback connection from an output of the second flip-flop Q2 via the controlled inverter M5, M6 for providing an input signal Q4 to the first flip-flop M1 - M4. The inverter M5, M6 delays the signal with a time delay depending on its geometry and on the technology used for its implementation. When the signals whose frequency needs to be divided have a period in the same range as the delay through the inverter M5, M6, the signal cannot be transmitted from the input of the controlled inverter to its output. Hence, the controlled inverter M5, M6 at the input limits the maximum frequency, which may be divided. The present invention is based on the inventive recognition that inverting the phase of the feedback signal from the second flip-flop allows for an elimination of the inverter M5, M6 and contributes to an increase of the maximum frequency of input signals, which are divided with this frequency divider.

In the invention, a controllable switch is coupled to the first data input and to the third output. The controllable switch is configured to be controlled by a clock signal driving the first flip-flop. When the delay through the inverters is not critical but still wants to obtain a frequency divider for relative high frequency signals from the controlled input inverter we remove one transistor and apply a clock signal substantially in phase with the clock signal of the first flip-flop. Hence, the maximum frequency of operation is increased when compared with the state of the art divider because the delay through the switch is smaller than the delay through two transistors implementing the controlled inverter.

Optionally, the controllable switch is coupled to the third output via resistive means. The resistive means reduces the current supplied to the input of the first flip-flop and the loading due to the input impedance of the first flip-flop. As a direct consequence, the consummated power is reduced.

The above and other features of the invention will be apparent from the following description of the exemplary embodiments of the invention with reference to the accompanying drawings, in which:
Fig. 1 depicts a prior-art R-S flip-flop,
Fig. 2 depicts a frequency divider using a prior-art flip-flop,
Fig. 3 depicts a frequency divider according to an embodiment of the invention, and
Fig. 4 depicts a frequency divider according to another embodiment of the invention.

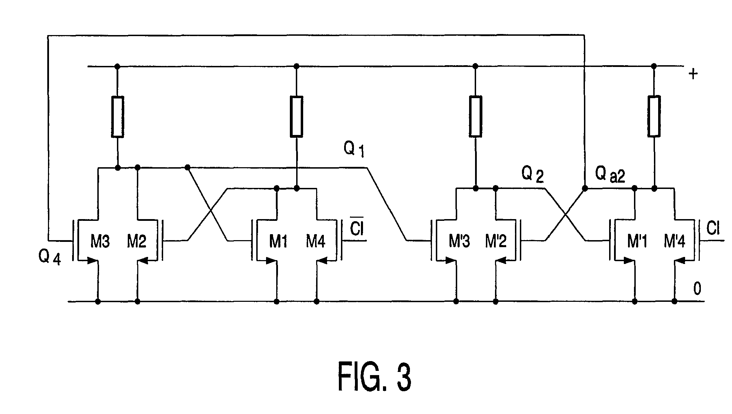

Fig. 3 depicts a frequency divider according to an embodiment of the invention.

The frequency divider comprises a first flip-flop M1, M2, M3, M4 having a first clock input C̅1̅ for receiving a clock signal. The flip-flop further comprises a first set input Q4 and a first non-inverted output Q1. The frequency divider further comprises a second flip-flop M1', M2', M3', M4' having a second clock input Cl for receiving a second clock signal that is substantially in anti-phase with the clock signal inputted into the first clock input C̅1̅, a second set input coupled to the first non-inverted output Q1, a second non-inverted output Q2 and a second inverted output Q̅2̅, the second inverted output Q̅2̅ being coupled to the first set input Q4. A period of the clock signal is of the same order of magnitude as a delay through an inverter stage of the divider.

In current CMOS technology the circuits used for frequency division are implemented in Current Mode Logic (CML) and specifically in Source Coupled Logic (SCL). When it is necessary to divide a signal having a relatively high frequency, e.g. 10 GHz current CMOS logic circuits are not suitable because it is necessary to have a relative low supply voltage for limiting the power dissipation. In these conditions, the necessary current sources for CML or SCL circuits suffer from a relatively large drain-to substrate capacitance of the MOS transistors. The frequency divider shown in Fig. 3 eliminates an inverter from the input of the used flip-flops. Because the inverter phase shifts the input signal with 180 degrees it is necessary to invert the input signal for obtaining the same division function as the prior-art divider. Hence, the input of the first flip-flop is coupled to the inverted output Q̅2̅ of the second flip-flop, which provides a signal substantially in anti-phase i.e. phase shifted over 180 degrees with respect to the signal provided by the second output Q2.

When the frequency of the clock signal Cl is substantially different from the delay through inverters implementing flip-flops, a controllable switch M7 is coupled to the first data input Q4 and to the third output Qa2. The switch is controlled by a clock signal driving the first flip-flop M1, M2, M3, M4. The maximum frequency of operation is increased when compared with the state of the art divider because the delay through the switch is smaller than the delay through two transistors implementing the controlled inverter. The controllable switch M7 may be coupled to the third output Qa2 via resistor R. The resistor R reduces the current supplied to the input of the first flip-flop and the loading due to the input impedance of the first flip-flop. As a direct consequence, the consummated power is reduced.

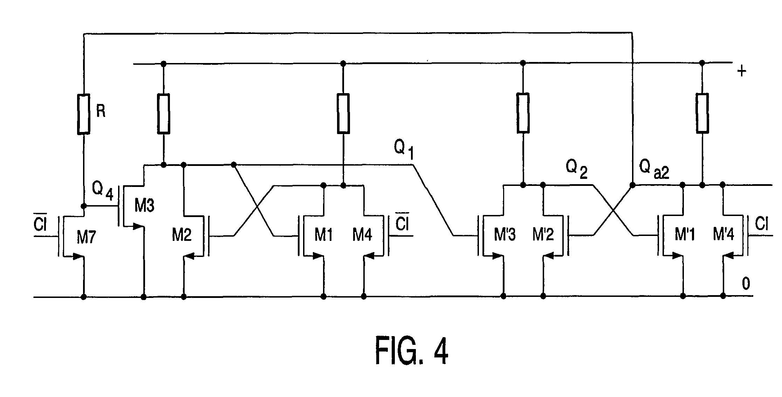

It should be mentioned here that the pairs of transistors M1, M4; and M2, M3 in Figs. 1 - 4 are in fact controlled inverters.

## Claims

1. A frequency divider comprising:
- a first flip-flop (Ml, M2, M3, M4) having a first clock input (C1') for receiving a first clock signal, the flip-flop further comprising a first set input (Q4) and a first non-inverted output (Q1), and
- a second flip-flop (M1', M2', M3', M4') having a second clock input (C1) for receiving a second clock signal that is substantially in anti-phase with the first clock signal, a second set input coupled to the first non-inverted output (Q1), a second non-inverted output (Q2) and a second inverted output (Q2'), the second inverted output (Q2') being coupled to the first set input (Q4),
**characterized in that** the frequency divider further comprises:
- a controllable switch (M7) coupled to the first set input (Q4) and to the second inverted output (Q2') and configured for being controlled by the first clock signal for allowing a period of the first clock signal to be substantially different from a delay through an inverter of one of the flip-flops.

2. A frequency divider as claimed in claim 1, wherein the controllable switch (M7) is coupled to the second inverted output (Q2') via resistive means (R).

## Patentansprüche

1. Ein Frequenzteiler aufweisend:
- ein erstes Flip-Flop (M1, M2, M3, M4), das einen ersten Takteingang (C1') zum Empfang eines ersten Taktsignal aufweist, wobei das Flip-Flop weiterhin einen ersten Geräteeingang (Q4) und einen ersten nicht-invertierenden Ausgang (Q1) aufweist, und
- ein zweites Flip-Flop (M1', M2', M3', M4') das einen zweiten Takteingang (C1) zum Empfang eines zweiten Taktsignals aufweist, welches im Wesentlichen in Gegenphase mit dem ersten Taktsignal ist, wobei ein zweiter Geräteeingang an den ersten nicht-invertierenden Ausgang (Q1), einen zweiten nicht-invertierenden Ausgang (Q2) und einen zweiten invertierenden Ausgang (Q2') gekoppelt ist, wobei der zweite invertierende Ausgang (Q2') an den ersten Geräteeingang (Q4) gekoppelt ist, **dadurch gekennzeichnet, dass** der Frequenzteiler weiterhin aufweist:
- einen ansteuerbaren Schalter (M7), der an den ersten Geräteeingang (Q4) und den zweiten invertierten Ausgang (Q2') gekoppelt ist und dazu eingerichtet ist, durch das erste Taktsignal derart geregelt zu werden, dass eine Periode des ersten Taktsignals im Wesentlichen unterschiedlich zu einer Verzögerung durch einen Inverter eines der Flip-Flops ist.

2. Ein Frequenzteiler gemäß Anspruch 1, wobei der ansteuerbaren Schalter (M7) über resistive Mittel (R) an den zweiten invertierenden Ausgang (Q2') gekoppelt ist.

## Revendications

1. Diviseur de fréquence comprenant :
- une première bascule (Ml, M2, M3, M4) ayant une première entrée d'horloge (C1') pour recevoir un premier signal d'horloge, la bascule comprenant en outre une première entrée à un (Q4) et une première sortie non inversée (Q1), et
- une seconde bascule (M1', M2', M3', M4') ayant une seconde entrée d'horloge (C1) pour recevoir un second signal d'horloge qui est sensiblement en opposition de phase avec le premier signal d'horloge, une seconde entrée à un couplée à la première sortie non inversée (Q1), une seconde sortie non inversée (Q2) et une seconde sortie inversée (Q2'), la seconde sortie inversée (Q2') étant couplée à la première entrée à un (Q4),
**caractérisé en ce que** le diviseur de fréquence comprend en outre :
- un commutateur pouvant être commandé (M7) couplé à la première entrée à un (Q4) et à la seconde sortie inversée (Q2') et configuré pour être commandé par le premier signal d'horloge pour permettre à une période du premier signal d'horloge d'être sensiblement différente d'un retard à travers un inverseur d'une des bascules.

2. Diviseur de fréquence selon la revendication 1, dans lequel le commutateur pouvant être commandé (M7) est couplé à la seconde la sortie inversée (Q2') par l'intermédiaire d'un moyen résistif (R).
